Europäisches Patentamt

European Patent Office

Office européen des brevets

(19)

(11) Publication number: **0 011 477**
**B1**

(12) # EUROPEAN PATENT SPECIFICATION

(45) Date of publication of patent specification: **20.07.83**

(21) Application number: **79302552.9**

(22) Date of filing: **13.11.79**

(51) Int. Cl.³: **H 01 L 21/00,**
**H 01 L 21/82,**
**H 01 L 21/28,**
**H 01 L 29/80, H 01 L 27/08**

(54) Self-aligned MESFET and method of making same.

(30) Priority: **13.11.78 US 959963**

(43) Date of publication of application:
**28.05.80 Bulletin 80/11**

(45) Publication of the grant of the patent:
**20.07.83 Bulletin 83/29**

(84) Designated Contracting States:
**DE FR GB**

(56) References cited:
**EP - A - 0 004 292**
**EP - A - 0 005 351**
**DE - A - 2 818 090**
**US - A - 3 906 541**
**US - A - 4 052 229**

**IEEE INTERNATIONAL ELECTRON DEVICES**
**MEETING: TECHNICAL DIGEST, Washington,**
**6th—8th December 1976, pages 593—596,**
**New York, U.S.A.,**
**V. L. RIDEOUT et al.: "Mosfet with Polysilicon**
**Gates Self-Aligned to the Field Isolation and to**
**the Source/Drain Regions"**

(73) Proprietor: **XEROX CORPORATION**
**Xerox Square - 020**
**Rochester New York 14644 (US)**

(72) Inventor: **Yeh, Keming W.**
**7810 Osage Avenue**
**Los Angeles, California (US)**

(74) Representative: **Goode, Ian Roy et al,**
**European Patent Attorney c/o Rank Xerox Patent**
**Department 338 Euston Road**
**London NW1 3BH (GB)**

## Self-aligned MESFET and method of making same

This invention relates to a self-aligned MESFET and a method of making simultaneously an enhancement switching MESFET and a depletion load MESFET with self-aligned structures from a substrate lightly doped with an acceptor (or donor) impurity, overlaid with relatively thin first and second areas alternating with area of thick field oxide, and with a heavy donor (or acceptor) impurity introduced into the substrate below the areas of thick oxide.

European patent application No 79300721.2 describes and claims a method of making a MESFET upon which the present invention is an improvement.

Although MESFETs have high device gain relative to MOSFETs and do not require a thin gate oxide which limits the ultimate advancement of MOS devices, MESFET devices have been relatively unnoticed in the past as a result of their large series source and drain resistances which tend to degrade the actual device gain more severely than MOSFET devices. MESFET structures would only become attractive if the series resistance could be reduced by advanced photolithographic techniques which have not been well developed for practical use.

Therefore, it is highly desirable to devise means to minimize these undesirable resistances in MESFET structures without requiring advanced photolithographic techniques to thus make MESFETS competitive with MOSFETs, and the present invention is intended to achieve this.

The invention accordingly provides a method of making a self-aligned MESFET which is characterised by the steps of:

a) introducing a relatively shallow donor (or acceptor) impurity in the substrate below the first and second thin oxide areas to define with graded profiles first and second light donor (or acceptor) areas therein;

b) masking to expose only the second thin oxide area for a relatively deep donor (or acceptor) impurity introduction in the second light donor (or acceptor) are so that the depletion load device will be normally-on;

c) layering an etch resistant mask over the surface of the first and second thin oxide areas to form a sandwich thereof, and etching away the thin oxide areas to expose the first and second light donor (or acceptor) areas except for narrowly defined first and second gate sandwiches defined to be over gate channel regions;

d) etching away the exposed first and second light donor (or acceptor) areas to a predetermined depth, and introducing a relatively heavy donor (or acceptor) impurity to define, within each of the light donor (or acceptor) areas, first and second heavy donor (or acceptor) areas as source and drain regions;

e) depositing polysilicon and etching away, through masking, all but areas that are adjacent to a heavy donor (or acceptor) area and a thick oxide area, for defining source and drain ohmic contacts, and reoxidizing over the polysilicon areas and part of first and second heavy donor (or acceptor) areas for inter-layer isolation; and

f) etching away first and second gate sandwiches thereby exposing first and second light donor (or acceptor) areas, and depositing schottky metal thereon for reaction into a schottky barrier for use as schottky contact.

The method of the invention produces a MESFET with the advantages of improved high device gain as a result of the elimination of series resistance, increased circuit integration density, and improved speed capability due to the elimination of spacings between gate and drain and gate and source and the improved high device gain.

A MESFET, and a method of making a MESFET, in accordance with the invention, will now be described, by way of example, with reference to the accompanying drawings, in which:—

Figure 1 is a cross-sectional view of a self-aligned MESFET device having reduced series resistance.

Figure 2 is a cross-sectional view of a conventional MESFET prior art devices.

Figure 3 is a diagram comparing the degradation effects of source resistance and drain resistance on a self-aligned MESFET of Figure 1 and a conventional prior art MESFET of Figure 2.

Figure 4A—H shows the processing steps involved in creating a self-aligned MESFET structure having reduced series resistance as shown in Figure 1.

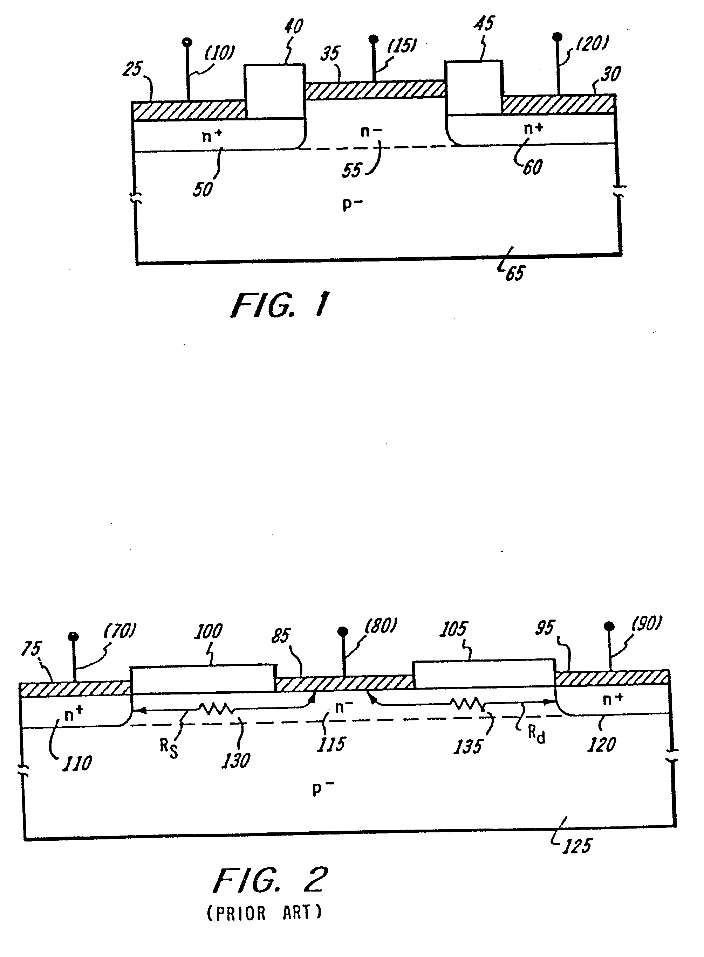

In Figure 1 we see a cross-sectional view of a self-aligned MESFET in accordance with the invention including a source electrode 10, gate electrode 15 and drain electrod 20. The ohmic contacts for the source electrode 10 and drain electrode 20 are of polysilicon (poly) or platinum-silicon compound 25 and 30 respectively. The gate schottky contact 35 is composed of a reacted platinum-silicon compound. Separating the source ohmic contact 25 from the gate schottky contact 35 is a field oxide barrier of silicon dioxide 40. Likewise, separating the gate schottky contact 35 from the drain ohmic contact 30 is a field oxide barrier of silicon dioxide 45. Underneath the oxide barrier 40 and the source electrode contact 25 is a N plus (+) conductive source region of area 50 implanted using the heavy dopant arsenic. Likewise, under the gate schottky contact 35 is a N minus (−) gate channel region or area 55 implanted with a graded doping profile using the dopant arsenic. Finally, under the oxide barrier 45 and the drain ohmic contact 30 is an N plus (+) conductive drain region or area 60 implanted using the heavy dopant arsenic.

It will be noted that the schottky contact 35 is disposed to be stepped-up and over the N— gate channel region 55 relative to the N+ source and drain conductive regions 50 and 60 thereby allowing the silicon dioxide areas 40 and 45 to electrically isolate the contact 15 from the regions 50 and 60. This isolation allows the contact 15 to function effectively as a schottky barrier. All the above areas are supported by a P minus (—) or Pi substrate 65. It will be further noted that the $R_s$ or source resistance and the $R_D$ or drain resistance approximate zero in the self-aligned MESFET and as such as not shown in Figure 2 (prior art).

In Figure 2 (prior art) there is shown a source electrode 70 connected to an ohmic contact 75 of polysilicon or platinum-silicon compound, a gate electrode 80 connected to a schottky contact 85 composed of a platinum-silicon compound, a drain electrode 90 connected to an ohmic contact 95 of polysilicon or platinum-silicon compound. Interposed between the source ohmic contact 75 and the gate schottky contact 85 is a silicon dioxide barrier 100 and likewise disposed between the gate schottky contact 85 and the drain ohmic 95 is also a silicon dioxide barrier 105. In the conductive channel region is a N plus (+) area 110 below the source ohmic contact 75, an N minus (—) area 115 below the silicon dioxide barriers 100 and 105 and the gate schottky contact 85, and an N plus (+) area 120 beneath the drain ohmic contact 95. Supporting all the above is a P minus (—) substrate 125. It will be noted that the source resistance $R_s$ is shown as 130 and the drain resistance $R_D$ is shown as 135 and is relatively substantial as compared to that of the inventive self-aligned MESFET of Figure 1.

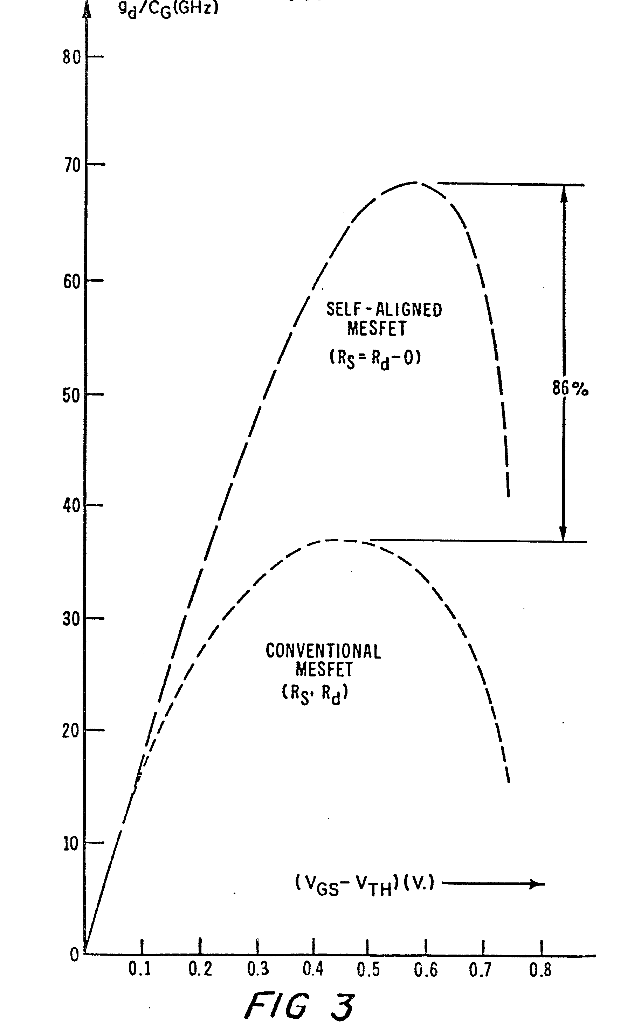

Referring to Figure 3, there is shown the comparison of the degradation effect of source resistance $R_s$ and drain resistance $R_D$ on a MESFET, $(g_d/c_g)$ where $g_d$ is device gain and $c_g$ is gate capacitance. The Y coordinate of Figure 3 is $g_d/c_g$ (GHZ) which represents the high speed or high frequency capability of the device and the X coordinate is Vgs—Vth) where Vgs is the gate source voltage and Vth is the threshold voltage. It will be noted that the $g_d/c_g$ is 86 percent higher in the self-aligned MESFET (where RS = RD = 0) than the conventional prior art MESFET.

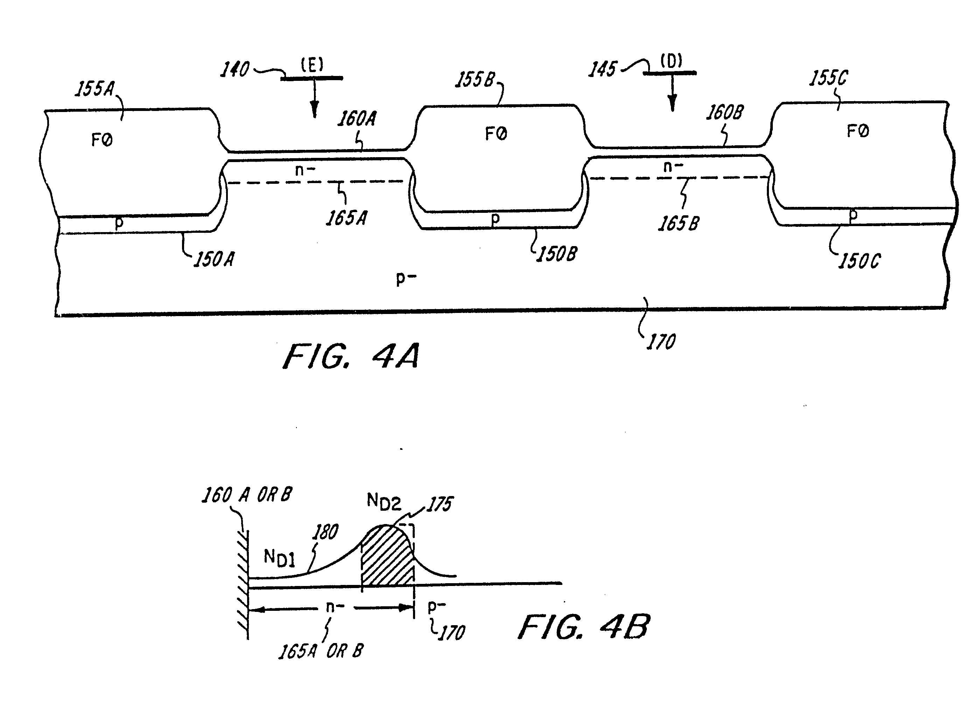

European Patent Application No. 79300721.2 shows and describes the conventional process required to get to the structural state shown in Figure 4A. In particular, the self-aligned MESFET process having double-layer interconnections comprises the following detailed steps. It should be noted as indicated supra that in the proposed fabrication process, an enhancement switching device and the depletion load device (basic inverter building block) are fabricated simultaneously. The enhancement switching device is indicated as the E switch 140 and the depletion load device is indicated as the D-load 145.

In the first step as shown in Figure 4A, an acceptor minus (P— or Pi) substrate 170, is overlaid with thick field oxidation or relatively thick areas 155A—C of field oxide alternating with thin areas 160A—B of field oxide with donor (P) implants 150A—C, or introduced by other means underlying the thick oxide 155A—C to prevent undesirable field inversion. The dopant arsenic is implanted, or introduced by other means, as an impurity through a 400A thin oxide or area of relatively thin oxide 160A—B to form the light donor N— areas 165A—B. It will be noted that the light donor or N— layer 165A—B has a graded doping profile, as shown in Figure 4B, where the device behaves similarly to a two step channel — doping MESFET. The main conduction channel ND2(175) is at the bottom layer where doping is the heaviest and the lighter doping being at ND1(180).

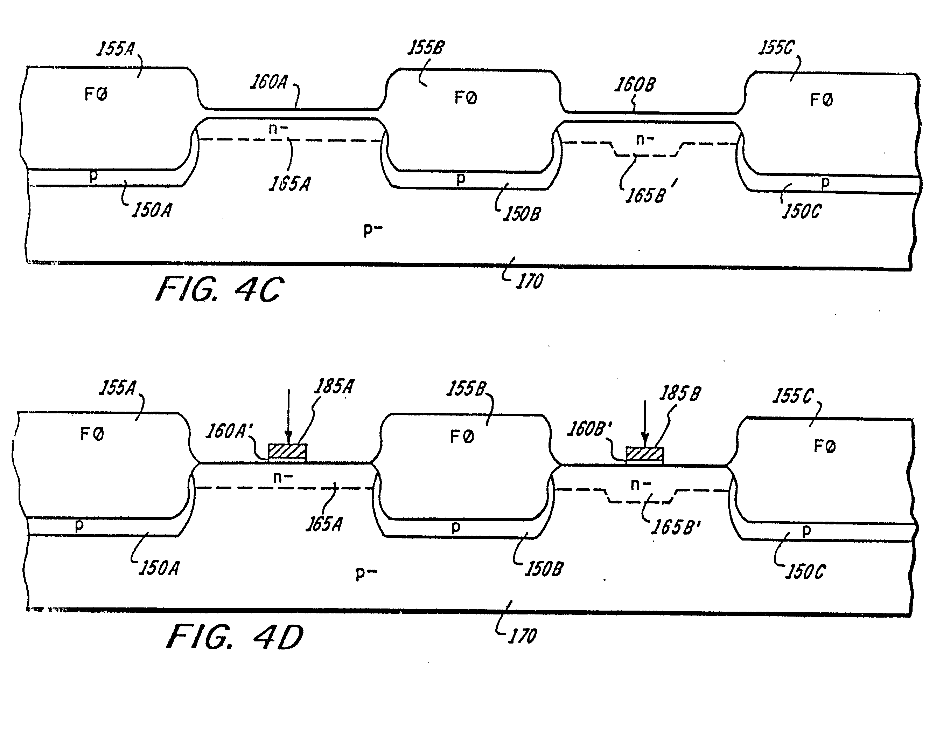

In the second step, as shown in Figure 4C, a mask is operative to expose the depletion device 145 for a relatively deep donor (N—) or arsenic implant, or introduced by other means, shown as 165B' to make a normally-on load device 145.

In the third step as shown in Figure 4D, a gate mask is used to define the narrow gate region to be protected by the silicon nitride 185A—B deposition which is previously applied. The unprotected silicon dioxide areas 160A—B are then etched away leaving only the protected areas, mainly silicon dioxide areas 160A' and 160B' under the silicon nitride areas 185A—B to form a spatially predetermined sandwich thereof.

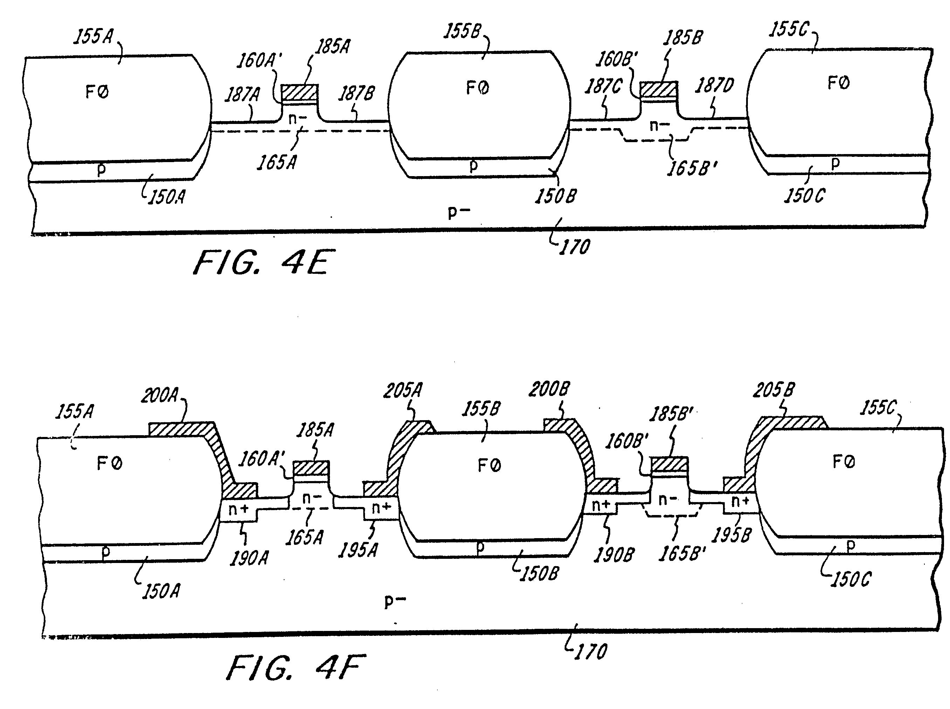

In the fourth step as shown in Figure 4E, silicon etching is applied using a plasma-etch process of KOH (or poly-etch) solution to the unprotected areas 187A—D of the N— channel region 165A—B' for removal thereof to approximately a depth of 2000A.

In the fifth step as shown in Figure 4F, source and drain heavy implants or introduction of arsenic dopant is used in the N— channels region 165A—B' to create N+ regions in selected areas therein at 190A—B and 195A—B. Subsequently, a polysilicon mask is used to define the circuit pattern in conductive poly-silicon (poly) at areas 200A and 200B as source ohmic contacts and 205A and 205B as drain ohmic contacts through the processes of poly deposition through diffusion then selective poly etching using polysilicon mask. The impurity making the polysilicon contacts conductive diffuses rapidly into the N+ region 190A—B and 195A—B causing those regions to be deeper under the contacts.

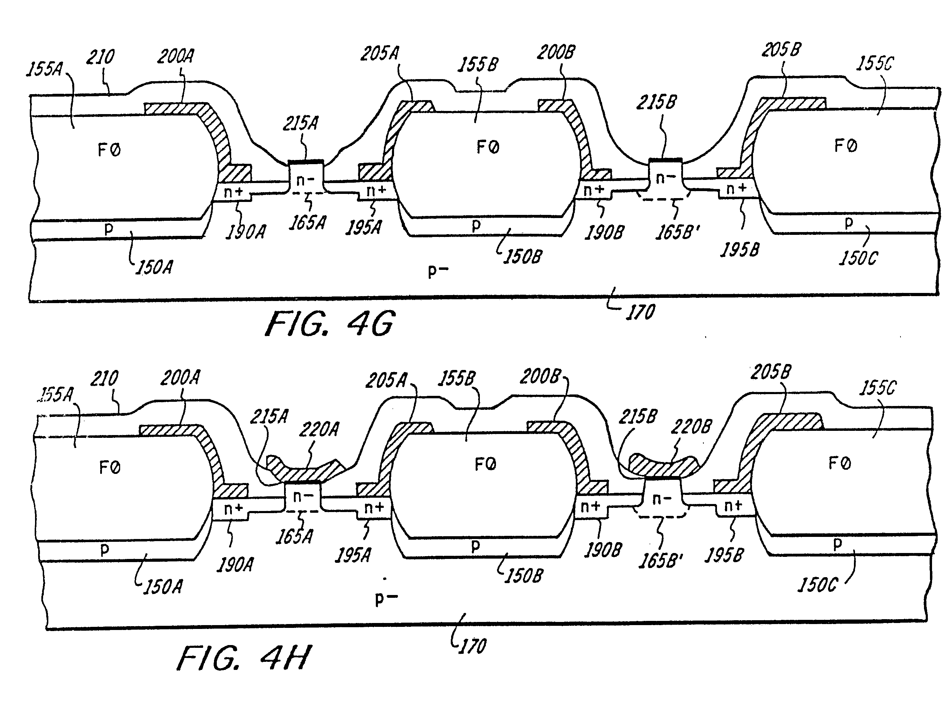

In step six there is shown in Figure 4G, a second oxidation or reoxidation indicated as 210 over the polysilicon areas 200A—B and 205A—B and also the N+ areas 190A—B and 195A—B and is operative to produce interlayer isolation. Next, the silicon nitride 185A—B and thin silicon oxide 160A—B' sandwiches are etched away. Replacing the silicon nitride and silicon dioxide, is platinum which is sputteringly deposited on 215A and 215B. Finally, a platinum silicon compound of schottky or barrier is reactively formed as a schottky contact at a predetermined temperature for a predetermined time which in this embodiment is 550 degrees C for 15 minutes in the sputtering vacuum chamber at the same areas 215A—B. A chemical solution is then used that will etch off the unreacted platinum while the platinum silicon 215A—B is unaffected.

In the seventh step as shown in Figure 4H, a second layer of metal interconnection which in this embodiment is aluminum is deposited and masked away over the platinum silicon schottky pbarrier 215A—B at 220A—B to leave a top metal of 220A—B. The passivation and contact-pad opening steps may be done afterwards as in a normal MOS—LSI process.

The above process results in fabrication of high-speed, high density, low power LSI circuits with improved high gain MESFET devices using conventional lithographic techniques. The advantages thereof include much improved high device gain as a result of the elimination of series resistances increased circuit integration density and improved speed capability due to the elimination of gate to source and gate to drain spacings and improved high device gain.

Note that the silicon etching step may be done by using plasma dry etching process, KOH chemical etching solution or polysilicon etching solution. The starting silicon wafers may be of 100, 110, or 111 orientations.

It will be noted that the supra self-aligned MESFET will also function in an equivalent manner if acceptors were to be used where donors are, and donors where acceptors are which is to day that the use of P or N material is equivalent as long as consistent with the above description.

**Claims**

1. A method of making simultaneously an enhancement switching MESFET and a depletion load MESFET with self-aligned structures from a substrate (170) lightly doped with an acceptor (or donor) impurity, overlaid with relatively thin first and second areas (160A—B) alternating with areas of thick field oxide (155A—C), and with a heavy donor (or acceptor) impurity (150A—C) introduced into the substrate below the areas of thick oxide, the method being characterised by the steps of:

a) introducing a relatively shallow donor (or acceptor) impurity in the substrate (170) below the first and second thin oxide areas (160A—B) to define with graded profiles first and second light donor (or acceptor) areas (165A—B) therein;

b) masking to expose only the second thin oxide area (160B) for a relatively deep donor (or acceptor) impurity introduction in the second light donor (or acceptor) area (165B) so that the depletion load device will be normally-on;

c) layering an etch resistant mask (185A—B) over the surface of the first and second thin oxide areas (160A—B) to form a sandwich thereof, and etching away the thin oxide areas to expose the first and second light donor (or acceptor) areas (165A—B) except for narrowly defined first and second gate sandwiches (160A$^1$—B$^1$) defined to be over gate channel regions;

d) etching away the exposed first and second light donor (or acceptor) areas to a predetermined depth (187A—D), and introducing a relative heavy donor (or acceptor) impurity to define, within each of the light donor (or acceptor) areas (165A, 165B$^1$), first and second heavy donor (or acceptor) areas (190A—B, 195A—B) as source and drain regions.

e) depositing polysilicon (200A—B, 205A—B and etching away, through masking, all but areas that are adjacent to a heavy donor (or acceptor) area and a thick oxide area, for defining source and drain ohmic contacts, and reoxidizing (210) over the polysilicon areas and part of first and second heavy donor (or acceptor) areas for inter-layer isolation; and

f) etching away first and second gate sandwiches (160A$^1$—B$^1$, 185A—B) thereby exposing first and second light donor (or acceptor) areas (165A—B), and depositing schottky metal (215A—B) thereon for reaction into a schottky barrier for use as a schottky contact.

2. The method of claim 1 including the additional step of depositing top metal over all exposed surfaces of the substrate, and masking away all of the top metal except that (220A—B) over the surface of the schottky contact for defining a gate electrode pattern.

3. The method of claim 1 or claim 2 wherein the etching used to form the drain and source regions (step (d)) is plasma etching.

4. The method of any one of claims 1 to 3 wherein the masking used to define the deposited polysilicon (step (e)) is a polysilicon masking step.

5. The method of any one of claims 1 to 4, wherein the metal used in the schottky metal depositing step (step (f)) is platinum and the reaction is between the platinum and silicon to form a compound thereof.

6. The method of claim 5 including the additional step of removing unreacted schottky metal from the schottky metal and silicon compound.

7. A self-aligned MESFET having a light acceptor (or donor) impurity doped substrates (65), light donor (or acceptor) means (55) disposed over the substrate (65) for operation as a gate channel region; first and second heavy donor (or acceptor) means (50, 60) disposed over the substrate (65) and adjacently stepped down on either side of said light donor (or acceptor) means (55) for operation as source and drain regions; schottky contact means (35) disposed over said light donor (or acceptor) means (55) for operation as a schottky barrier; and first and second ohmic contact means (25, 30) disposed over a predetermined portion of said first and second heavy donor (or acceptor) means (50, 60) for source and drain connections; characterised in that the light donor (or acceptor) means (55) has a graded doping profile, and in that first and second oxide means (40, 45) are disposed laterally between said schottky contact means (35) and each of said first and second ohmic contact means (25, 30), and disposed over a predetermined portion of said first and second heavy donor (or acceptor) means (50, 60) for inter-layer isolation relative to said light donor (or acceptor) means (55).

**Revendications**

1. Procédé de fabrication simultanée d'un MESFET de commutation à effet d'enrichissement et d'un MESFET à charge d'appauvrissement avec des structure auto-alignées à partir d'un substrat (170) légèrement dopé avec une impureté d'accepteur (ou de donneur) recouvert de première et seconde zones relativement fines (160A—B) alternant avec des zones d'oxyde de champ épais (155A—C), et avec une impureté de donneur (ou accepteur) lourd (150A—C) introduite dans le substrat au-dessous des zones d'oxyde épais, le procédé étant caractérisé par les étapes suivantes:

a) l'introduction d'une impureté de donneur (ou accepteur) relativement peu profonde dans le substrat (170) au-dessous des première et seconde zones d'oxyde épais (160A—B) pour définir avec des profils graduels des première et seconde zones de donneur (ou accepteur) léger (165A—B);

b) le masquage de manière à n'exposer que la seconde zone d'oxyde fin (160B) pour l'introduction d'une impureté de donneur (ou accepteur) relativement profonde dans la seconde zone (165B) de donneur (ou d'accepteur) léger de manière que le dispositif à charge d'appauvrissement soit normalement conducteur;

c) la formation d'une couche d'un masque résistant à l'attaque (185A—B) sur la surface des première et seconde zones d'oxyde fin (160A—B) de manière à former un sandwich, et l'attaque des zones à oxyde fin de manière à exposer les première et seconde zones de donneur (ou accepteur) léger (165A—B) à l'exception de premier et second sandwichs de grille (160A$^1$—B$^1$) définis étroitement pour être sur les régions de canal de grille;

d) l'attaque des première et seconde zones de donneur (ou accepteur) léger exposées jusqu'à une profondeur prédéterminée (187A—D), et l'introduction d'une impureté de donneur (ou accepteur) relativement lourde pour définir, à l'intérieur de chacune des zones (165A, 165B$^1$) de donneur (ou accepteur) léger, des première et seconde zones (190A—B, 195A—B) de donneur (ou accepteur) lourd comme régions de source et de drain;

e) le dépôt de polysilicium (200A—B, 205A—B) et l'attaque, par l'intermédiaire d'un masque, de toutes les zones à l'exception des zones qui sont contiguës à la zone de donneur (ou accepteur) lourd et à une zone d'oxyde épais, pour définir des contacts ohmiques de source et de drain, et une réoxydation (210) au-dessus des zones de polysilicium et d'une partie des première et seconde zones de donneur (ou accepteur) lourd pour un isolement entre couche; et

f) l'attaque des premier et second sandwichs de grille (160A$^1$—B$^1$, 185A—B), exposant ainsi des première et seconde zones de donneaur (ou accepteur) léger (165A—B), et le dépôt de métal supérieur sur toutes les surfaces extion afin de donner une barrière schottky destinée à être utilisée en contact schottky.

2. Procédé selon la revendication 1, comprenant l'étape supplémentaire de dépôt de métal supérieur sur troutes les surfaces exposées du substrat, et l'attaque avec masque de la totalité de ce métal à l'exception de celui (220A—B) se trouvant sur la surface du contact schottky pour définir un motif d'électrode de grille.

3. Procédé selon la revendication 1 ou 3, où l'attaque servant à former les régions de drain et de source (étape (d)) est une attaque au plasma.

4. Procédé selon l'une quelconque des revendications 1à 3, où le masquage servant à définir le polysilicium déposé (étape (e)) est une étape de masquage de polysilicium.

5. Procédé selon l'une quelconque des revendications 1 à 4, où le métal utilisé dans l'étape de dépôt de métal schottky (étape (f)) est du platine et la réaction se produit entre le platine et la silicium pour former un composé de ceux-ci.

6. Procédé selon la revendication 3, comprenant l'étape supplémentaire d'enlèvement du métal schottky n'ayant pas réagi du composé de métal schottky et de silicium.

7. MESFET auto-aligné comportant des substrats (65) dopés en impureté d'accepteur (ou de donneur) léger, un moyen (55) de donneur léger (ou accepteur) disposé sur le substrat (65) pour fonctionnement comme une région de canal de grille; des premier et second moyens (50, 60) de donneur (ou accepteur) lourd disposés sur le substrat (65) et échelonnés de manière contiguë de chaque côté du moyen (55) de donneur léger (ou accepteur) pour fonctionnement comme région de source et de drain, un moyen de contact schottky (35) disposé sur le moyen (55) de donneur léger (ou accepteur) pour fonctionnement comme barrière schottky; et des premier et second moyens de contact ohmiques (25, 30) disposés sur une partie prédéterminée des premier et second moyens (50, 60) de donneur lourd (ou accepteur) pour des connexions de source et de drain, caractérisé en ce que le moyen (55) de donneur léger (ou accepteur) a un profil de dopage graduel, et en ce que des premier et second moyens d'oxyde (40, 45) sont latéralement disposés entre le moyen de contact schottky (35) et chacun des premier et second moyens de contact ohmiques (25, 30), et disposés sur une partie prédéterminée du premier et second moyens (50, 60) de donneur (ou accepteur) lourd pour isolement entre-couche vis-à-vis du moyen (55) de donneur (ou accepteur) léger.

## Patentansprüche

1. Ein Verfahren zum gleichzeitigen Herstellen eines Anreicherungs-Schalt-MESFET und eines Verarmungs-Last-MESFET mit selbstausrichtenden Strukturen aus einem Substrat (170), das mit einer Akzeptor-Verunreinigung oder einer Donator-Verunreinigung schwach dotiert ist, und auf dem relativ dünne erste und zweite Bereiche (160A—B) abwechselnd mit Bereichen von dicken Feld-Oxyden (155A—C) darüberliegend angeordnet sind, und mit einer starken Donator-Verunreinigung (oder Akzeptor-Verunreinigung) (150A—C), die in das Substrat unterhalb der Bereiche des dicken Oxydes eingebracht ist, gekennzeichnet durch folgende Verfahrensschritte:

a) Einführen einer relativ flachen Donator-Verunreinigung (oder Akzeptor-Verunreinigung) in das Substrat (170) unterhalb der ersten und zweiten dicken Oxydbereiche (160A—B), um mit abgestuften Profilen erste und zweite schwache Donator-Bereiche (oder Akzeptor-Bereiche) (165A—B) in dem Substrat festzulegen;

b) Maskieren, um lediglich den zweiten dünnen Oxydbereich (160B) einem Einbringen einer relativ tiefen Donator-Verunreinigung (oder Akzeptor-Verunreinigung) in den zweiten schwachen Donator-Bereich (oder Akzeptor-Bereich) (165B) auszusetzen, so daß das Verarmungs-Last-Gerät normalerweise eingeschaltet sein wird;

c) Aufbringen einer einem Ätzen widerstehenden Maske (185A—B) auf die Oberfläche der ersten und zweiten dünnen Oxydbereiche (160A—B), um hieraus eine geschichtete Struktur zu bilden, un Wegätzen der dünnen Oxydbereiche, um die ersten und zweiten leichten Donator-Bereiche (oder Akzeptor-Bereiche) (165A—8) mit Ausnahme von in enger Weise festgelegten ersten und zweiten Gate-Schichtstrukturen (160A¹—B¹) freizulegen, welche festgelegt sind, um oberhalb der Gate-Kanalregionen zu sein;

d) Wegätzen der freiliegenden ersten und zweiten leichten Donator-Bereiche (oder Akzeptor-Bereiche) bis zu einer vorbestimmten Tiefe (187A—D), und Einbringen einer relativ starken Donator-Verunreinigung (oder Akzeptor-Verunreinigung), um erste und zweite starke Donator-Bereiche (oder Akzeptor-Bereiche) (190A—B, 195A—B) als Source-Regionen und als Drain-Regionen innerhalb jedes leichten Donator-Bereiches (oder Akzeptor-Bereiches) (165A, 165B¹) festzulegen;

e) Ablagern von Polysilizium (200A—B, 205A—B) und Wegätzen mittels Maskierens von allen Bereichen mit Ausnahme von denen, die an die starken Donator-Bereiche (oder Akzeptor-Bereiche) und einen dicken Oxyd-Bereich angrenzen, um Ohm'sche Source-Kontakte und Drain-Kontakte festzulegen, und Oxydieren (210) der Polysilizium-Bereiche und eines Teils der ersten und zweiten Starken Donator-Bereiche (oder Akzeptor-Bereiche), um eine Zwischenschicht-Isolation zu schaffen; und

f) Wegätzen der ersten und zweiten Gate-Schicht-strukturen (160A¹—B¹, 185A—B), um dadurch erste und zweite schwache Donator-Bereiche (oder Akzeptor-Bereiche) (165A—B) freizulegen, und Ablagern von Schottky-Metall (215A—B) hierauf, für eine Reaktion zu einer Schottky-Barriere, um als Schottky-Kontakt verwendet zu werden.

2. Verfahren nach Anspruch 1, mit dem zusätzlichen Verfahrensschritt des Ablagerns eines oberen Metalles über alle freiliegenden Flächen des Substrates, und des Abdeckens des gesamten oberen Metalles mit Ausnahme desjenigen (220A—B) oberhalb der Oberfläche des Schottky-Kontaktes, um eine Gate-Elektrodenmuster festzulegen.

3. Verfahren nach Anspruch 1 oder Anspruch 2, bei dem das Ätzen, das zum Bilden der Drain-Regionen und der Source-Regionen (Verfahrensschritt d)) verwendet wird, ein Plasma-Ätzen ist.

4. Verfahren nach einem der Ansprüche 1 bis 3, bei dem das Maskieren, das zum Festlegen des abgelagerten Polysiliziums (Verfahrensschritt e)) verwendet wird, ein Polysilizium-Maskierungs-Verfahrensschritt ist.

5. Verfahren nach einem der Ansprüche 1 bis 4, bei dem das Metall, das in dem Schottky-Metal Ablagerungs-Verfahrensschritt (Verfahrensschritt f)) verwendet wird, Platin ist, und bei dem die Reaktion zwischen Platin und Silizium stattfindet, um einen Verbund dieser Stoffe zu bilden.

6. Verfahren nach Anspruch 5, mit dem zusätzlichen Verfahrensschritt des Entfernens von nicht-reagiertem Schottky-Metall von dem Verbund aus Schottky-Metall und Silizium.

7. Ein selbst-ausrichtender MESFET mit einem mittels einer leichten Akzeptor-Verunreinigung (oder Donator-Verunreinigung) dotierten Substrat (65), mit einer leichten Donator-Einrichtung (oder Akzeptor-Einrichtung) (55), die oberhalb des Substrates (65) angeordnet ist, um als Gate-Kanal-Region zu wirken; mit einer ersten und zweiten starken Donator-Einrichtung (oder Akzeptor-Einrichtung) (50, 60), die oberhalb des Substrates (65) angeordnet ist und benachbart liegend auf jeder Seite der leichten Donator-Einrichtung (oder Akzeptor-Einrichtung (55) herabgestuft ist, um als Source-Region und Drain-Region zu arbeiten; mit einer Schottky-Kontakt-Einrichtung (35), die Oberhalb der leichten Donator-Einrichtung (oder Akzeptor-Einrichtung) (55) angeordnet ist, um als Schottky-Barriere zu arbeiten; und mit einer ersten und zweiten Ohm'schen Kontakt-Einrichtung (25, 30), die oberhalb eines vorbestimmten Teiles der ersten und zweiten starken Donator-Einrichtung (oder Akzeptor-Einrichtung) (50, 60) angeordnet ist, um Source-Verbindungen und Drain-Verbindungen zu bilden; dadurch gekennzeichnet, daß die schwache Donator-Einrichtung (oder Akzeptor-Einrichtung) (55) ein gestuftes Dotierungsprofil hat, und daß die erste und zweite Oxydeinrichtung (40, 45) seitlich zwischen der Schottky-Kontakt-Einrichtung (35) und jeder der ersten und zweiten Ohm'schen Kontakt-Einrichtungen (25, 30) angeordnet ist, und oberhalb eines vorbestimmten Teiles der ersten und zweiten starken Donator-Einrichtung (oder Akzeptor-Einrichtung) (50, 60) für eine Zwischenschicht-Isolation bezüglich der leichten Donator-Einrichtung (oder Akzeptor-Einrichtung) (55) angeordnet ist.

FIG. 1

FIG. 2

(PRIOR ART)

1

FIG 3

FIG. 4A

FIG. 4B

FIG. 4C

FIG. 4D

FIG. 4E

FIG. 4F

5

FIG. 4G

FIG. 4H